Europäisches Patentamt

European Patent Office

Office européen des brevets

(11) Veröffentlichungsnummer: **0 314 873 B1**

# EUROPÄISCHE PATENTSCHRIFT

(45) Veröffentlichungstag der Patentschrift: **29.04.92**

(51) Int. Cl.⁵: **H04N 5/46**, H04N 17/04

(21) Anmeldenummer: **88110430.1**

(22) Anmeldetag: **30.06.88**

(54) **Einrichtung zum automatischen Anlegen der Abgleichspannung an die abstimmbaren Schaltungselemente des ZF-Verstärkers eines Fernsehempfängers.**

(30) Priorität: **05.11.87 DE 3737581**

(43) Veröffentlichungstag der Anmeldung:
**10.05.89 Patentblatt 89/19**

(45) Bekanntmachung des Hinweises auf die
Patenterteilung:
**29.04.92 Patentblatt 92/18**

(84) Benannte Vertragsstaaten:
**AT BE CH DE FR GB IT LI**

(56) Entgegenhaltungen:
**DE-A- 3 120 050**

**Fernseh-und Kino-Technik, 40. Jahrgang, Nr. 5, 1986, Heidelberg; Henning Schwarz, Wolfgang Welters-bach:"Mehrnormen-Fernsehempfänger, eine Übersicht" - Seiten 193-200**

(73) Patentinhaber: **GRUNDIG E.M.V. Elektro-Mechanische Versuchsanstalt Max Grundig holländ. Stiftung & Co. KG.**
**Kurgartenstrasse 37**
**W-8510 Fürth/Bay.(DE)**

(72) Erfinder: **Rehak, Manfred GRUNDIG E.M.V. Elektro-Mechanische Versuchsanstalt Max Grundig Hol-länd.Stiftung&CoKG**
**Kurtgartenstrasse 37 D-8510Fürth/Bay(DE)**

## Beschreibung

Die Erfindung betrifft eine Einrichtung zum automatischen Anlegen der Abgleichspannungen an die abstimmbaren Schaltungselemente des ZF-Verstärkers eines Fernsehempfängers mit den im Oberbegriff des Anspruchs 1 angegebenen Merkmalen.

Der ZF-Verstärker eines Fernsehempfängers enthält Filterschaltungen, die vorgeschriebene Frequenzselektionseigenschaften aufweisen müssen. Die Filterschaltungen selbst enthalten abstimmbare Schaltungselemente wie veränderbare Spulen, Kondensatoren oder Kapazitätsdioden. Aufgrund von Fertigungstoleranzen müssen diese Schaltungselemente nach Beendigung des Fertigungsvorganges abgeglichen werden, um die Fertigungstoleranzen derart zu kompensieren, daß die genannten Schaltungselemente und damit die Filterschaltungen die vorgeschriebenen Frequenzselektionseigenschaften haben. Dieser Abgleich wurde anfänglich von Hand durchgeführt und war damit mühsam und zeitaufwendig.

Aus der DE-OS 32 34 236 ist es bereits bekannt, den Abgleich automatisch durchzuführen. Hierzu ist eine elektronische Einstellvorrichtung mit einem programmierbaren Nurlesespeicher (PROM) vorgesehen, welcher als Steuerelement zur Abspeicherung, Ableitung und Zuführung geeigneter Einstell- und Steuersignale zum Abgleich verwendet wird. Innerhalb des programmierbaren Nurlesespeichers ist jedem abzugleichenden Schaltungselement ein Speicherplatz zugeordnet, an dem ein dem Abgleichwert des Schaltungselementes entsprechendes Digitalwort abgespeichert ist. Dieses Digitalwort wird im Anschluß an den Fertigungsvorgang unter Verwendung von geeigneten Testsignalen ermittelt. Das abgespeicherte Digitalwort wird im Betrieb der Schaltung über einen D/A-Wandler, der aus dem Digitalwort eine (analoge) Abgleichspannung erzeugt, dem entsprechenden Schaltungselement zugeführt.

Ausgehend von diesem Stand der Technik liegt der Erfindung die Aufgabe zugrunde, eine Einrichtung zum automatischen Anlegen der Abgleichspannungen an die abstimmbaren Schaltungselemente des ZF-Verstärkers eines Fernsehempfängers anzugeben, der zum Empfang von Fernsehsendungen unterschiedlicher Fernsehstandards (B, G, L, I, ...) ausgerüstet ist.

Diese Aufgabe wird durch eine Einrichtung mit den im Anspruch 1 angegebenen Merkmalen gelöst. Vorteilhafte Weiterbildungen der Erfindung sind in den Unteransprüchen beschrieben.

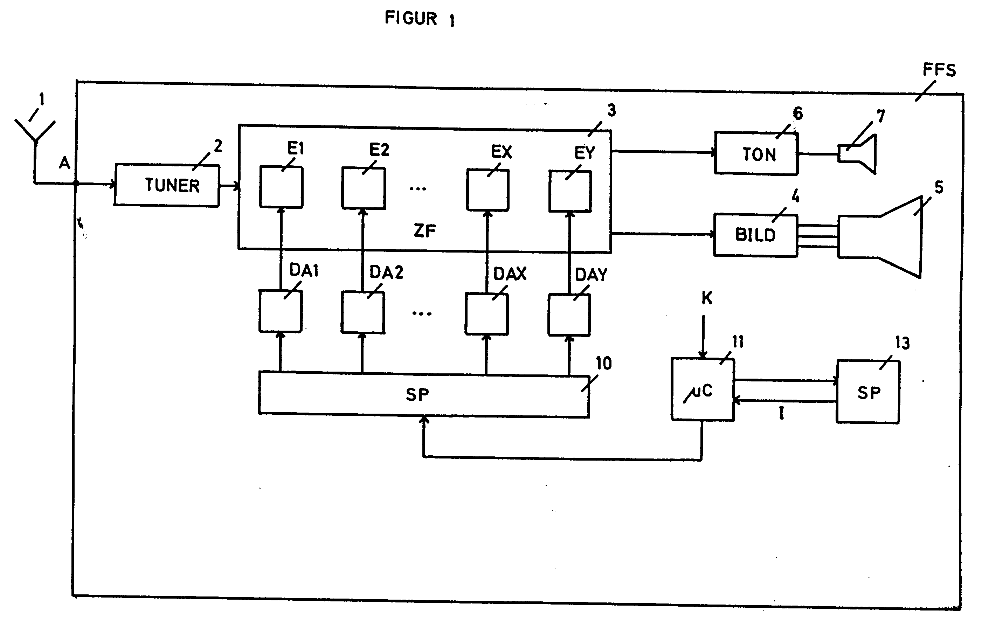

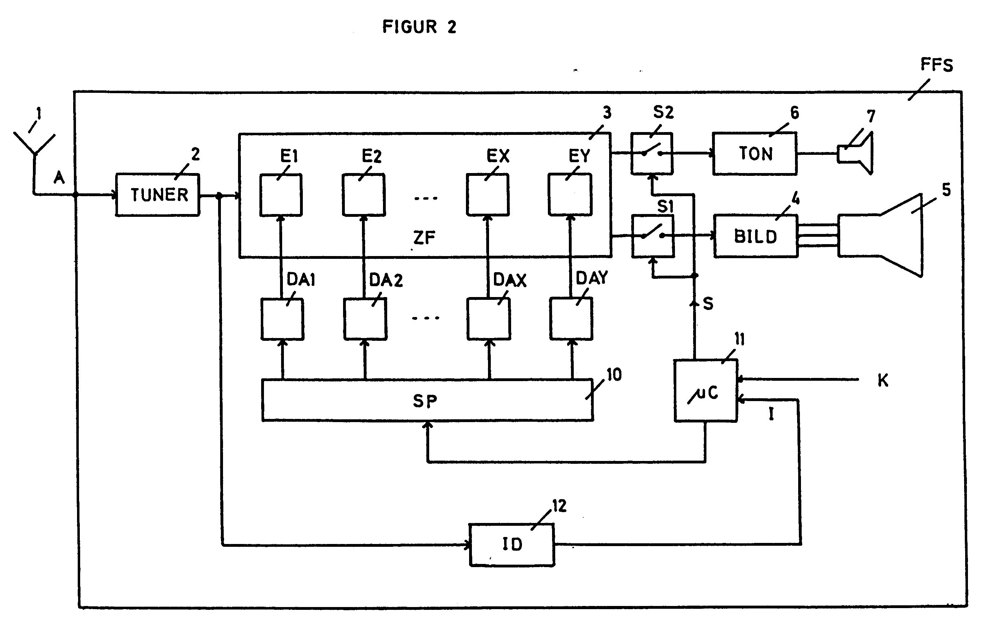

Die mit der beanspruchten Einrichtung erzielbaren Vorteile ergeben sich anhand von Ausführungsbeispielen, welche im folgenden mit Hilfe der Figuren 1 und 2 näher erläutert werden.

Es zeigt:

Fig.1 ein erstes Ausführungsbeispiel für einen Multistandard-Farbfernsehempfänger nach der vorliegenden Erfindung, und

Fig.2 ein zweites Ausführungsbeispiel für einen Multistandard-Farbfernsehempfänger nach der vorliegenden Erfindung.

Die Figur 1 zeigt einen Multistandard-Farbfernsehempfänger FFS, welcher zum Empfang von Signalen der Fernsehstandards B, G, L, I, ..., ausgerüstet ist.

Im Normalbetrieb des Fernsehempfängers wird ein von der Hausantenne 1 empfangenes Farbfernsehsignal dem Antennenanschluß A zugeführt. Von dort aus gelangt es in grundsätzlich bekannter Weise über einen Tuner 2, eine ZF-Stufe 3 und eine Bildsignalverarbeitungsschaltung 4 an die Bildröhre 5 bzw. über eine Tonsignalverarbeitungsschaltung 6 an die Lautsprecher 7 des Fernsehempfängers.

Die ZF-Stufe 3 weist mehrere Filterschaltungen auf, die der ZF-Stufe vorgeschriebene Frequenzselektionseigenschaften verleihen. Den Filterschaltungen gehören abstimmbare Schaltungselemente wie veränderliche Spulen, Kondensatoren und Kapazitätsdioden an. Jedem dieser abstimmbaren Schaltungselemente muß im Normalbetrieb eine Abgleichspannung zugeführt werden, wodurch der ZF-Stufe die vorgeschriebene Frequenzselektionseigenschaft verliehen wird.

Die Frequenzselektionseigenschaft der ZF-Stufe 3 ist vom Standard des empfangenen Signals abhängig, d.h. jedem der abstimmbaren Schaltungselemente muß eine vom Standard des momentan empfangenen Signals abhängige Abgleichspannung zugeführt werden. Folglich wird für jeden Fernsehstandard ein Satz von Abgleichspannungen benötigt, wobei der erste Satz von Abgleichspannungen an die abstimmbaren Schaltungselemente angelegt wird, wenn das momentan empfangene Signal vom Standard B ist, der zweite Satz von Abgleichspannungen an die abstimmbaren Schaltungselemente angelegt wird, wenn das momentan empfangene Signal vom Standard L ist, der dritte Satz von Abgleichspannungen an die abstimmbaren Schaltungselemente angelegt wird, wenn das momentan empfangene Signal vom Standard I ist, usw.

Diese Abgleichspannungen für jeden Standard werden im Anschluß an den Fertigungsvorgang unter Verwendung von geeigneten Testsignalen ermittelt und in Form von Digitalwörtern unter bestimmten Adressen des Speichers 10 abgelegt. Die im Betrieb jeweils benötigten Digitalwörter werden bei Bedarf unter Steuerung durch einen Mikrocomputer 11 aus dem Speicher 10 ausgelesen und den abzustimmenden Schaltungselementen E1, E2, ...,

EX, EY über D/A-Wandler DA1, DA2, ..., DAX, DAY, in denen die Dititalwörter in analoge Abgleichspannungen umgewandelt werden, zugeführt.

Der Mikrocomputer 11 benötigt zur Adressierung des Speichers 10 ein Kennsignal I für den Standard des momentan empfangenen Farbfernsehsignals.

Dieses Kennsignal I entnimmt der Mikrocomputer 11 einem Speicher 13. Im folgenden wird beschrieben, wie die Abspeicherung des Kennsignals I im Speicher 13 erfolgt. Bei der Abstimmung des Tuners 2 wird jeder Kanalwahltaste des Fernsehempfängers eine bestimmte Empfangsfrequenz fest zugeordnet. Hierzu wird dem Fernsehempfänger zunächst durch Betätigung eines Schalters eine Information darüber zugeführt, welchem Fernsehstandard das zuzuordnende Fernsehsignal angehören soll. Anschließend wird die gewünschte Kanalwahltaste betätigt. Danach wird entweder durch direkte Kanaleingabe oder durch einen Suchlaufvorgang eine gewünschte Empfangsfrequenz eingestellt bzw. ermittelt und durch Betätigung einer Speichertaste eine feste Zuordnung zwischen Kanalwahltaste und Empfangsfrequenz hergestellt. Durch diese Betätigung der Speichertaste wird gleichzeitig ein Kennsignal I für den Standard des Fernsehsignals in einem Speicher 13 abgelegt. Dieser Vorgang wird für sämtliche Kanalwahltasten wiederholt. Nach Beendigung der Tunerabstimmung ist folglich im Speicher 13 für jede Kanalwahltaste ien Kennsignal für den Standard des der Kanalwahltaste zugeordneten Fernsehsignals abgespeichert.

Im Betrieb des Fernsehempfängers erhält der Mikrocomputer 11 bei Betätigung einer Kanalwahltaste ein Kanalwahlsignal k zugeführt. Anschließend liest der Mikrocomputer 11 aus dem Speicher 13 das der betätigten Kanalwahltaste zugeordnete Kennsignal I für den Standard des im gewählten Kanal empfangenen Signals aus. Unter Auswertung dieses Kennsignals I adressiert der Mikrocomputer 11 den Speicher 10 derart, daß die dem Standard des momentan empfangenen Signals entsprechenden Digitalwörter ausgelesen und in Form von Abgleichspannungen an die abstimmbaren Schaltungselemente E1, E2 ..., EX, EY der ZF-Stufe angelegt werden.

Auch die Figur 2 zeigt einen Multistandard-Fernsehempfänger FFS, welcher zum Empfang von Signalen der Fernsehstandards B, G, L, I, ... ausgerüstet ist. Dieser Empfänger unterscheidet sich von dem in Figur 1 gezeigten im wesentlichen durch die Art und Weise der Erzeugung des Kennsignals I.

Zur Erzeugung des Kennsignals I ist bei dem in Figur 2 gezeigten Empfänger an den Ausgang des Tuners 2 eine Standarderkennungsschaltung 12 angeschlossen. Diese ermittelt durch Auswertung von Kriterien wie Positiv-oder Negativmodulation, Synchronimpulsabstand, Bildträger-Tonträger-Abstand, usw., den Standard des am Ausgang des Tuners 2 anliegenden Fernsehsignals und erzeugt das genannte Kennsignal I, welches dem Mikrocomputer 11 zugeführt wird. Bei dieser Ausführungsform erzeugt der Mikrocomputer 11 unmittelbar nach jeder Betätigung einer Kanalwahltaste ein Schaltsignal S. Dieses steuert einen im Weg des Bildsignals liegenden Schalter S1 und einen im Weg des Tonsignals liegenden Schalter S2 solange undurchlässig, bis der Standard des momentan empfangenen Signals (von der Standarderkennungsschaltung 12) erkannt wurde und der Mikrocomputer 11 die dem erkannten Standard entsprechenden Abgleichspannungen an die abstimmbaren Schaltungselemente E1, E2, ..., EX, EY angelegt hat. Dadurch wird vermieden, daß in der Zeit zwischen der Kanalumschaltung und der korrekten Arbeitsweise der ZF-Stufe undefinierte Signale an die Bildröhre 5 bzw. die Lautsprecher 7 des Multistandard-Fernsehempfängers gelangen können.

## Patentansprüche

1.  Einrichtung zum automatischen Anlegen der Abgleichspannungen an die abstimmbaren Schaltungselemente des ZF-Verstärkers eines Fernsehempfängers, mit
    - einem Speicher zur Abspeicherung von Digitalwörtern, die den Abgleichspannungen entsprechen,
    - Digital/Analogwandlern, in denen die Digitalwörter in die Abgleichspannungen umgewandelt werden, und
    - einer Steuerschaltung zur Steuerung des Anlegens der Abgleichspannungen an die abstimmbaren Schaltungselemente, dadurch gekennzeichnet, daß
    - für einen Multistandardbetrieb der Steuerschaltung (11) ein Kennsignal (I) für den Standard des momentan empfangenen Signals zugeführt wird,
    - im Speicher (10) für jedes der abstimmbaren Schaltungselemente (E1, E2, ..., EX, EY) mehrere Digitalwörter abgespeichert sind, wobei jedes Digitalwort der Abgleichspannung des zugehörigen abstimmbaren Schaltungselementes für einen Fernsehstandard entspricht, und
    - die Steuerschaltung (11) unter Auswertung des Kennsignals (I) den Speicher (10) derart adressiert, daß das dem Standard des momentan empfangenen Signals entsprechende Digitalwort aus dem Speicher ausgelesen wird.

**2.** Einrichtung nach Anspruch 1, dadurch gekennzeichnet, daß

- beim Tunerabstimmvorgang jeder Kanalwahltaste des Fernesehempfängers ein Kennsignal (I) für den Standard des in diesem Kanal empfangenen Signals zugeordnet,
- das Kennsignal (I) in einem Speicher (13) abgelegt, und
- im Normalbetrieb bei Betätigung einer Kanalwahltaste das dieser Taste zugeordnete Kennsignal (I) aus dem Speicher (13) ausgelesen und der Steuerschaltung (11) zugeführt wird.

**3.** Einrichtung nach Anspruch 1, dadurch gekennzeichnet, daß

- das Kennsignal (I) für den Standard des momentan empfangenen Signals während des Normalbetriebes in einer Standarderkennungsschaltung (12) erzeugt wird, und
- die Standarderkennungsschaltung (12) der Steuerschaltung (11) das Kennsignal (I) zuführt.

**4.** Einrichtung nach Anspruch 3, dadurch gekennzeichnet, daß die Standarderkennungsschaltung (12) an den Ausgang des Tuners (2) des Fernsehempfängers angeschlossen ist.

**5.** Einrichtung nach Anspruch 3 oder 4, dadurch gekennzeichnet, daß im Bildsignalkanal ein Schalter (S1) und im Tonsignalkanal ein Schalter (S2) vorgesehen ist, welche von der Steuerschaltung (11) unmittelbar nach jeder Betätigung einer Kanalwahltaste solange undurchlässig gesteuert werden, bis die Steuerschaltung (11) die dem Standard des momentan empfangenen Signals entsprechenden Abgleichspannungen an die abstimmbaren Schaltungselemente (E1, E2, ..., EX, EY) angelegt hat.

**Claims**

**1.** Device for automatically applying the calibration voltages to the tunable circuit elements of the IF amplifier of a television receiver, comprising

- a memory for storing digital words which correspond to the calibration voltages,
- digital/analog converters in which the digital words are converted into the calibration voltages, and
- a control circuit for controlling the application of the calibration voltages to the tunable circuit elements,
characterised in that

- an identification signal (I) for the standard of the currently received signal is supplied for the control circuit (11) for multistandard operation,
- several digital words are stored in the memory (10) for each of the tunable circuit elements (E1, E2,... EX, EY), each digital word corresponding to the calibration voltage of the associated tunable circuit element for one television standard, and
- the control circuit (11), by evaluating the identification signal (I), addresses the memory (10) in such a manner that the digital word corresponding to the standard of the currently received signal is read out of the memory.

**2.** Device according to Claim 1, characterised in that

- during the tuner tuning process, to each channel selection key of the television receiver an identification signal (I) for the standard of the signal received in this channel is allocated,
- the identification signal (I) is stored in a memory (13), and
- in normal operation, when a channel selection key is operated, the identification signal (I) allocated to this key is read out of the memory (13) and supplied to the control circuit (11).

**3.** Device according to Claim 1, characterised in that

- the identification signal (I) for the standard of the currently received signal is generated in a standard recognition circuit (12) during normal operation, and
- the standard recognition circuit (12) supplies the identification signal (I) for the control circuit (11).

**4.** Device according to Claim 3, characterised in that the standard recognition circuit (12) is connected to the output of the tuner (2) of the television receiver.

**5.** Device according to Claim 3 or 4, characterised in that a switch (S1) is provided in the picture signal channel and a switch (S2) is provided in the sound signal channel, which are controlled to be blocked by the control circuit (11) immediately after each time a channel selection key has been operated, until the control circuit (11) has applied the calibration voltages corresponding to the standard of the currently received signal to the tunable circuit elements (E1, E2,...EX, EY).

## Revendications

1. Dispositif pour l'application automatique des tensions d'équilibrage aux éléments de circuit accordables de l'amplificateur de fréquence intermédiaire d'un récepteur de télévision, comportant
   - une mémoire pour mémoriser des mots numériques, qui correspondent aux tensions d'équilibrage,
   - des convertisseurs numérique/analogique, dans lesquels les mots numériques sont convertis en les tensions d'équilibrage, et
   - un circuit de commande servant à commander l'application des tensions d'équilibrage aux éléments de circuit accordables,
   caractérisé en ce que
   - pour un fonctionnement suivant plusieurs normes, un signal caractéristique (I) concernant la norme du signal momentanément reçu est envoyé au circuit de commande (11),
   - plusieurs mots numériques sont mémorisés dans la mémoire (10) pour chacun des éléments de circuit accordables (E1,E2,..., EX, EY), chaque mot numérique correspondant à la tension d'équilibrage de l'élément de circuit accordable associé, pour une norme de télévision, et
   - le circuit de commande (11) adresse la mémoire (10), sur la base de l'évaluation du signal caractéristique (I), de telle sorte que le mot numérique correspondant à la norme du signal momentanément reçu est lu à partir de la mémoire.

2. Dispositif selon la revendication 1, caractérisé en ce que
   - lors d'une opération de réglage d'accord à l'aide d'un syntoniseur, à chaque touche de sélection d'un canal du récepteur de télévision est associé un signal caractéristique (I) concernant la norme du signal reçu dans ce canal,
   - le signal caractéristique (I) est mémorisé dans une mémoire (13), et
   - pendant le fonctionnement normal, lors de l'actionnement d'une touche de sélection de canal, le signal caractéristique (I) associé à cette touche est lu à partir de la mémoire (13) et est envoyé au circuit de commande (11).

3. Dispositif selon la revendication 1, caractérisé en ce que :
   - le signal caractéristique (I) pour la norme du signal momentanément reçu est produit, pendant le fonctionnement normal, dans un circuit (12) d'identification de normes, et
   - le circuit (12) d'identification de normes envoie le signal caractéristique (I) au circuit de commande (11).

4. Dispositif selon la revendication 3, caractérisé en ce que le circuit (12) d'identification de normes est raccordé à la sortie du syntoniseur (2) du récepteur de télévision.

5. Dispositif selon la revendication 3 ou 4, caractérisé en ce qu'un interrupteur (S1) est prévu dans le canal du signal image et un interrupteur (S2) est prévu dans le canal du signal son, ces interrupteurs étant commandés à l'état bloqué par le circuit de commande (11) juste après chaque actionnement d'une touche de sélection d'un canal, jusqu'à ce que le circuit de commande (11) ait appliqué les tensions d'équilibrage, qui correspondent à la norme du signal instantanément reçu, aux éléments de circuit accordables (E1, E2,..., EX, EY).

FIGUR 1

FIGUR 2

EP 0 314 873 B1